# EUROPEAN PATENT APPLICATION

(11) **EP 4 451 312 A1**
(43) Date of publication of application: **23.10.2024**
(21) Application number: 22906937.2
(22) Date of filing: 05.09.2022
(51) Int. Cl.: H01L 21/02, G05B 19/418

(54) **SEMICONDUCTOR DEVICE MANAGEMENT SYSTEM AND SEMICONDUCTOR DEVICE MANAGEMENT METHOD**

(30) Priority: 17.12.2021 JP 2021205116
(71) Applicant: Hitachi, Ltd., Tokyo 100-8280 (JP)
(72) Inventor: KONISHI, Kumiko, Tokyo 100-8280 (JP); OKINO, Hiroyuki, Tokyo 100-8280 (JP); BU, Yuan, Tokyo 100-8280 (JP); SHIMA, Akio, Tokyo 100-8280 (JP)
(74) Representative: MERH-IP Matias Erny Reichl Hoffmann Patentanwälte PartG mbB
(86) International application number: PCT/JP2022/033323
(87) International publication number: WO 2023/112401

(57) **Abstract**

A semiconductor device management system includes an arithmetic operation device for executing a predetermined process, an input section for receiving an input of data, and an output section for outputting an execution result of the process. The arithmetic operation device includes an adaptability calculation section for calculating adaptability of a semiconductor device formed on a semiconductor substrate for each application using three-dimensional position information of a crystal defect contained in the semiconductor substrate, an influence rate of a defect with respect to a device specification, and an operation condition of the semiconductor device for each application, and a determination section for determining each application to the semiconductor devices based on the adaptability. The determination section generates data for outputting at least each of the determined applications.

## Description

### INCORPORATION BY REFERENCE

This application claims the benefit of foreign priority to Japanese Patent Application No. JP2021-205116, filed December 17, 2021, which is incorporated by reference in its entirety.

### Technical Field

The present invention relates to a semiconductor device management system.

### Background Art

Aiming at attaining carbon neutrality, implementation of next-generation power semiconductor devices has been proceeded in various fields. Through such efforts, it is expected to reduce the loss of the power converter, and improve reliability. Meanwhile, the semiconductor substrate as a material for producing the semiconductor device contains a wide variety of crystal defects and structure defects. Influences of those defects on reliability of the device may differ depending on the defect information (defect type, size, position), and the device application (automobile, train). The semiconductor devices, however, have been manufactured in the semiconductor manufacturing process prescribed for the designated application irrespective of the crystal defects and the structure defects contained in the semiconductor substrate.

Each of Patent Literatures described below discloses the method for manufacturing the semiconductor device using position information of the crystal defect of the semiconductor substrate. Patent Literature 1 (Japanese Patent Application Laid-Open No. 2020-4856) discloses the method for manufacturing the semiconductor apparatus. The method includes the steps of preparing a semiconductor wafer, detecting crystal defects on the surface of, and the inside of the semiconductor wafer, dividing the semiconductor wafer into a normal part and a defect part based on the position at which the crystal defect is detected, forming multiple semiconductor elements on the semiconductor wafer, and inspecting electrical characteristics of the semiconductor elements formed as the normal parts by removing those having the defect parts from the semiconductor elements 3 to be inspected.

Patent Literature 2 (Japanese Patent Application Laid-Open No. 2019-192859) discloses the method for manufacturing the semiconductor apparatus which includes a first silicon carbide substrate, and an epitaxial layer formed on the first silicon carbide substrate. The method for manufacturing the silicon carbide semiconductor apparatus includes a first step for acquiring defect position information of the epitaxial layer, a second step for acquiring micropipe position information of a second silicon carbide substrate which has been cut from the same crystal as that of a first silicon carbide substrate, and a third step for comparing the defect position information of the epitaxial layer with the micropipe position information of the second silicon carbide substrate to determine the position of the micropipe that exists in the epitaxial layer.

### Summary of Invention

### Technical Problem

As described above, the semiconductor devices have been manufactured by executing the semiconductor manufacturing process prescribed for the designated application irrespective of the crystal defects or the structure defects contained in the semiconductor substrate. As a result, a part of the semiconductor devices manufactured on the semiconductor substrate may become defective, failing to attain reliability in the designated application. This may lower the resultant manufacturing yield.

In the background art as described above, the performance division of the chip having the defect is defined by the position of the defect contained in the semiconductor substrate. The performance division is determined without considering the information about the application or operation conditions of the semiconductor device to be manufactured.

It is an object of the present invention to provide a highly reliable semiconductor device at low costs by determining at least one of the manufacturing process or the application based on the position information of the crystal defect contained in the semiconductor substrate as the material, and results of classification by the application. Solution to Problem

A typical example of the present invention as disclosed herein is explained as below. That is, the semiconductor device management system includes an arithmetic operation device for executing a predetermined process, an input section for receiving an input of data, and an output section for outputting an execution result of the process. The arithmetic operation device includes an adaptability calculation section for calculating adaptability of a semiconductor device formed on a semiconductor substrate for each application using three-dimensional position information of a crystal defect contained in the semiconductor substrate, an influence rate of a defect with respect to a device specification, and an operation condition of the semiconductor device for each application, and further includes a determination section for determining each application to the semiconductor devices based on the adaptability. The determination section generates data for outputting at least each of the determined applications. Advantageous Effects of Invention

According to an aspect of the present invention, it is possible to manufacture the semiconductor device selectively using.the semiconductor substrate adapted to the device operation condition which differs with the application, and further to selectively ship the semiconductor device manufactured at the position in the substrate that satisfies the device operation condition. It is thus possible to provide a highly reliable semiconductor device at low costs. Problems, configurations, and advantageous effects except those described above will be clarified by explanations of the examples as described below.

### Brief Description of Drawings

Fig. 1 is an overall view representing a solution provided by a semiconductor device management system.
Fig. 2 shows a hardware structure of the semiconductor device management system, and a structure constituted by devices connected to the semiconductor device management system.
Fig. 3 shows a logical structure of the semiconductor device management system.
Fig. 4 is a sequence diagram of processing executed by the semiconductor device management system.
Fig. 5 is a sequence diagram of processing executed by a semiconductor device management system according to a first modification.
Fig. 6 is a sequence diagram of processing executed by a semiconductor device management system according to a second modification.
Fig. 7 is a sequence diagram of processing executed by a semiconductor device management system according to a third modification.
Fig. 8 is a sequence diagram of processing executed by a semiconductor device management system according to a fourth modification.
Fig. 9 is a flowchart of matching rate calculation processing.
Fig. 10 shows an example of a structure of three-dimensional defect information in a table form.
Fig. 11 shows an example of a structure of a defect influence rate in a table form.
Fig. 12. shows an example of a structure of a device operation condition in a table form.
Fig. 13 shows an example of a structure of a matching rate in a table form.
Fig. 14 shows an example of a structure of a matching rate in a table form.
Fig. 15 shows an example of a structure of a defect inactivating rate.
Fig. 16 shows an example of a structure of a defective/relief rate.
Fig. 17 shows an example of a matching rate display screen.
Fig. 18 shows an example of an application classification result display screen.

### Description of Embodiments

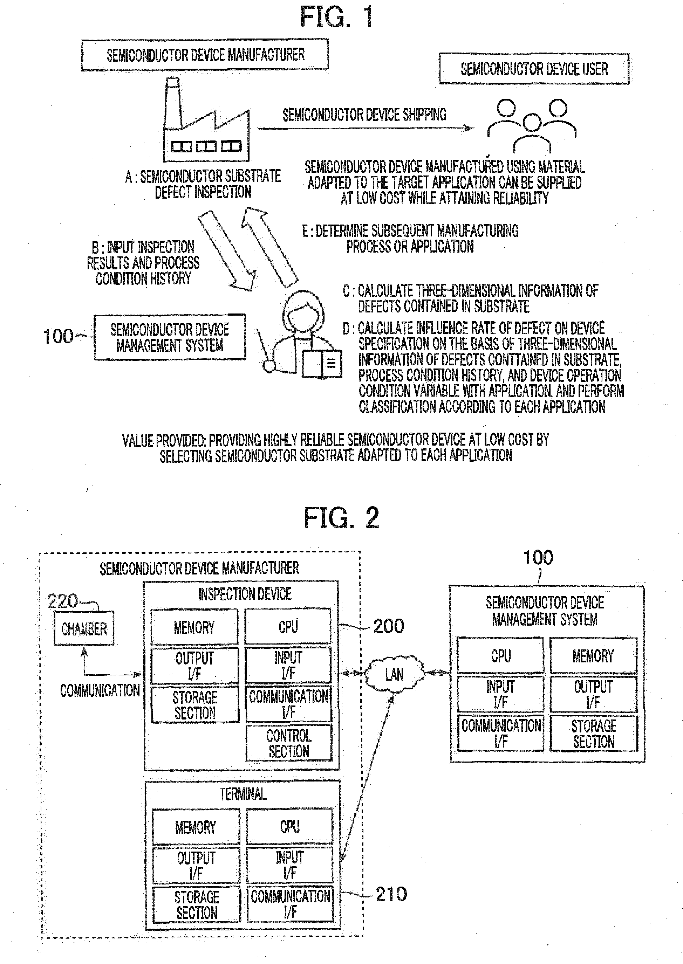

Fig. 1 is an overall view representing the solution provided by a semiconductor device management system 100 according to an example.

The semiconductor device management system 100 according to the example provides the highly reliable semiconductor device at low costs by selecting the semiconductor substrate adapted to each application.

A semiconductor device manufacturer inspects the defect of the semiconductor substrate (step A), and inputs inspection results and process condition history into the semiconductor device management system 100 (step B).

The semiconductor device management system 100 calculates three-dimensional information of the defect contained in the semiconductor substrate from the input inspection result (step C), and calculates the influence rate of the defect with respect to the device specification using the calculated three-dimensional information of the defect, the input process condition history, and predetermined device operation conditions for the respective applications, and classifies the semiconductor substrate by the application (step D). Then the semiconductor device manufacturer determines the subsequent manufacturing process or the application (step E), and ships the manufactured semiconductor device to a user of the semiconductor device.

Manufacturing of the semiconductor device using results of arithmetic operations by the semiconductor device management system 100 allows the use of the material adapted to the target application. This makes it possible to supply the semiconductor device which attains reliability at low costs.

Fig. 2 shows a hardware structure of the semiconductor device management system 100 according to the example, and a structure constituted by devices connected to the semiconductor device management system 100.

The semiconductor device management system 100 according to the example is constituted by a computing machine including a processor (CPU), memory, storage section, communication interface, input interface, and output interface.

The processor is an arithmetic operation device which executes the program stored in the memory, and constitutes an arithmetic operation section 110. The processor executes the program stored in a storage section 120 to implement functions of the respective function sections (for example, a defect analysis section 111, defective/relief rate calculation section 112, matching rate calculation section 113, application classification section 114, listing section 115, determination section 116) of the semiconductor device management system 100. Processing of the program to be executed by the processor may be partially executed by other arithmetic operation devices (for example, hardware such as ASIC and FPGA) .

The memory includes a ROM as a non-volatile memory element and a RAM as a volatile memory element. The ROM stores an invariant program (for example, BIOS). The RAM is a fast-speed volatile memory element such as a DRAM (Dynamic Random Access Memory) for temporarily storing the program to be executed by the processor, and data used for executing the program.

The storage section is constituted by a non-volatile storage device with large capacity, for example, a magnetic storage device (HDD) and a flash memory (SSD) for storing the program to be executed by the processor (a defect analysis program 131, defective/relief rate calculation program 132, matching rate calculation program 133, application classification program 134, listing program 135, determination program 136), and data to be used by the processor for executing the program (for example, a substrate information 141, defect inspection result 142, three-dimensional defect information 143, defect influence rate 144, device operation condition 145, process condition history 146, defective/relief rate 147, matching rate 148, application classification result 149, defect inactivating rate 150). The program is read from the storage section, loaded into the memory, and executed by the processor to implement the respective function sections of the semiconductor device management system 100.

The communication interface is a network interface device which controls communication with other devices (for example, an inspection device 200, a terminal 210) in accordance with a predetermined protocol. The semiconductor device management system 100 is connected to the inspection device 200, and the terminal 210 via a network (LAN, for example).

Input devices such as a keyboard, touch panel, and mouse are connected to the input interface for reception of an input from an operator. Output devices such as a display device and printer are connected to the output interface for outputting program execution results in the form visually recognizable by the operator. The input and output devices may be provided by the terminal 210 connected to the semiconductor device management system 100 via the network. In this case, the terminal 210 may be configured to access the semiconductor device management system 100 having the web server function using the predetermined protocol (http, for example).

The program to be executed by the processor is supplied to the semiconductor device management system 100 via a removable medium (CD-ROM, flash memory), or the network, and stored in a non-volatile storage section as a non-temporal storage medium. The semiconductor device management system 100 may be provided with the interface for reading data from the removable medium.

The semiconductor device management system 100 as a computing machine system physically constituted on a single unit of the computing machine, or logically or physically constituted on multiple computing machines may be operated on a virtual computing machine configured on multiple physical computing machine resources. For example, the defect analysis section 111, defective/relief rate calculation section 112, matching rate calculation section 113, application classification section 114, listing section 115, and determination section 116 may be operated on the individual physical or logical computing machines, respectively. Alternatively, multiple sections are combined and operated on a single unit of the physical or logical computing machine.

The inspection device 200, the terminal 210, and a semiconductor manufacturing apparatus (chamber) 220 are installed in the semiconductor device manufacturer.

The inspection device 200 includes the processor (CPU), memory, storage device, communication interface, input interface, output interface, control unit, and inspects a defect of the semiconductor substrate. Following the instruction from the terminal 210, the inspection device 200 connected to the semiconductor device management system 100 via the network transmits inspection results of the semiconductor substrate to the terminal 210. The inspection results may be directly transmitted to the semiconductor device management system 100. The inspection device 200 is communicably connected to the semiconductor manufacturing apparatus 220 to allow transmission of the process condition history 146 collected from the semiconductor manufacturing apparatus 220 to the semiconductor device management system 100.

The terminal 210 is constituted by a computing machine having a processor (CPU), memory, storage device, communication interface, input interface, output interface, and receives arithmetic operation results (for example, influence rate of the defect with respect to the device specification, classification of the semiconductor substrate) output from the semiconductor device management system 100.

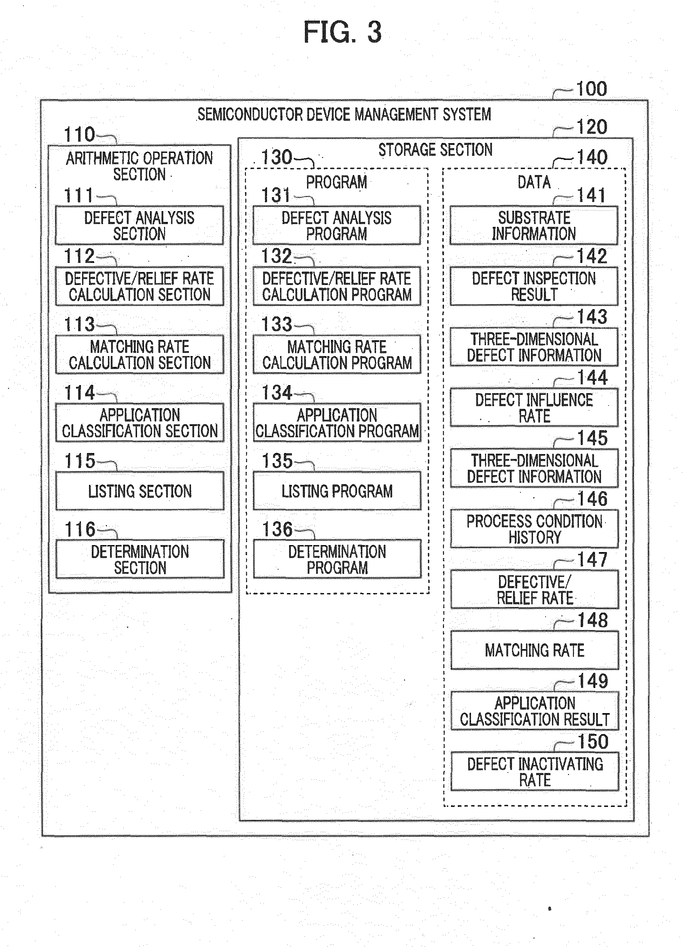

Fig. 3 represents the logical structure of the semiconductor device management system 100 of the example.

The semiconductor device management system 100 includes the arithmetic operation section 110 to be implemented through execution of the program by the processor, and the storage section 120 which stores a program 130 and data 140.

The arithmetic operation section 110 implements the defect analysis section 111, defective/relief rate calculation section 112, matching rate calculation section 113, application classification section 114, listing section 115, and determination section 116 by executing the program.

The program 130 stored in the storage section 120 includes the defect analysis program 131, defective/relief rate calculation program 132, matching rate calculation program 133, application classification program 134, listing program 135, and determination program 136.

The defect analysis program 131 is executed to allow the defect analysis section 111 to analyze a three-dimensional defect of the semiconductor substrate from the inspection results of the semiconductor substrate.

The defective/relief rate calculation program 132 is executed to allow the defective/relief rate calculation section 112 to calculate a probability (defective rate) that electrical characteristics of the semiconductor device formed on the semiconductor substrate deviate from the desired condition, and a probability (relief rate) that the electrical characteristics satisfy the desired conditions (conforming product) through inactivation of the defective area by changing the manufacturing process after occurrence of the defect. Both probabilities are calculated for each device application.

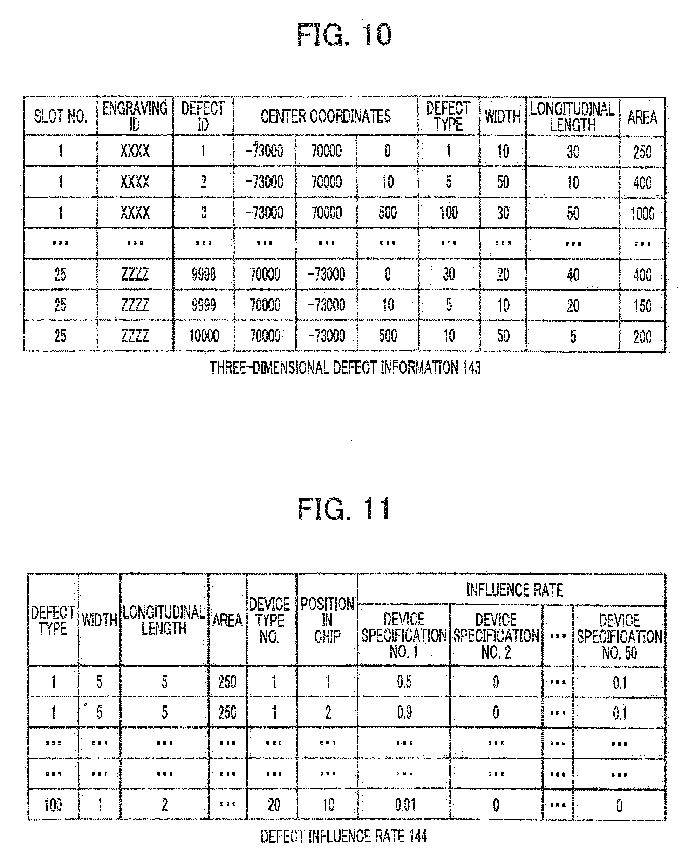

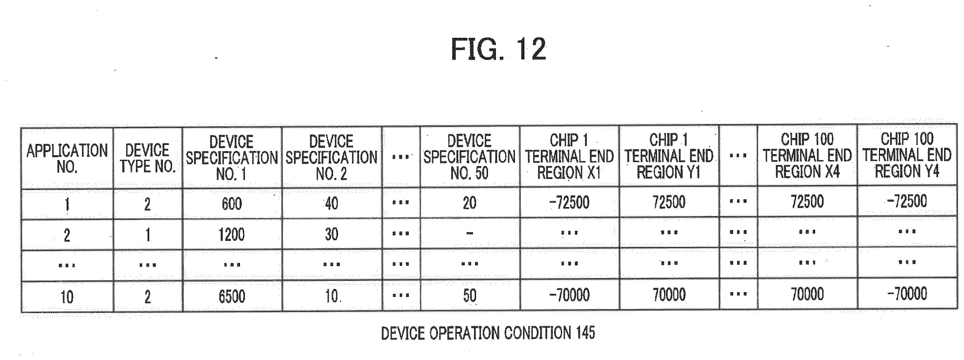

The matching rate calculation program 133 is executed to allow the matching rate calculation section 113 to calculate the matching rate of the semiconductor substrate or the chip for each device application using the input crystal defect information of the semiconductor substrate (see Fig. 10), the defect influence rate 144 (see Fig. 11) with respect to the device specification, and the device operation condition 145 for each application (see Fig. 12). The matching rate is expressed by a numerical value ranging from 0 to 1, serving as an index indicating adaptability of a certain semiconductor substrate (or the chip formed on the semiconductor substrate) to the semiconductor device for a specific application. The numerical value 0 represents that there is no adaptability.

The application classification program 134 is executed to allow the application classification section 114 to classify the semiconductor substrate (or the chip formed on the semiconductor substrate) in accordance with the calculated matching rate 148. The listing program 135 is executed to allow the listing section 115 to make a list of the classification results 149 by the application of the semiconductor substrate (or the chip formed on the semiconductor substrate). The determination program 136 is executed to allow the determination section 116 to determine the semiconductor substrate (or the chip formed on the semiconductor substrate) using the listed result.

The data 140 stored in the storage section 120 include the substrate information 141, defect inspection result 142, three-dimensional defect information 143, defect influence rate 144, device operation condition 145, process condition history 146, defective/relief rate 147, matching rate 148, application classification result 149, and defect inactivating rate 150.

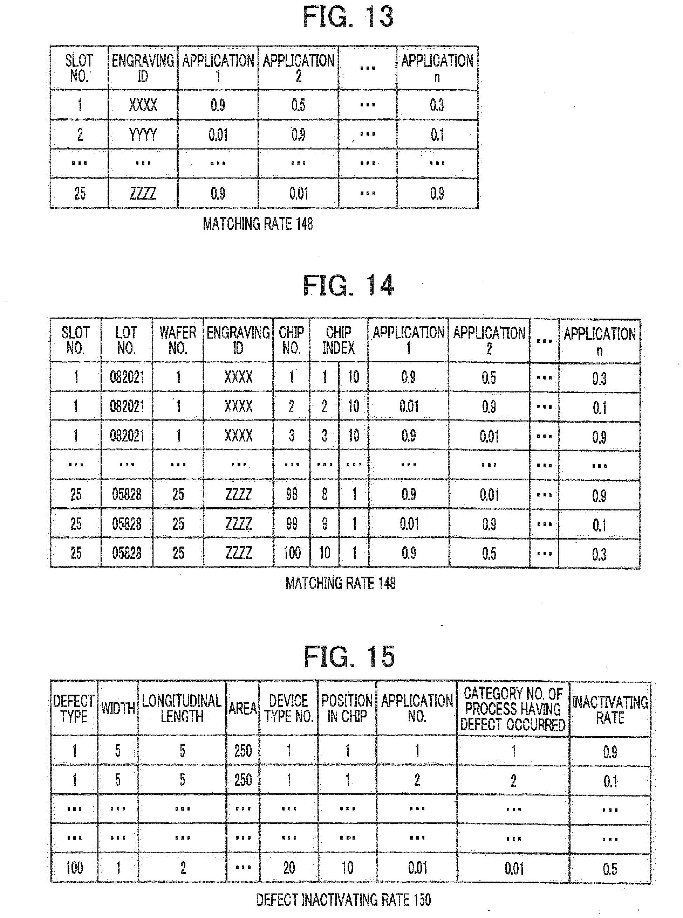

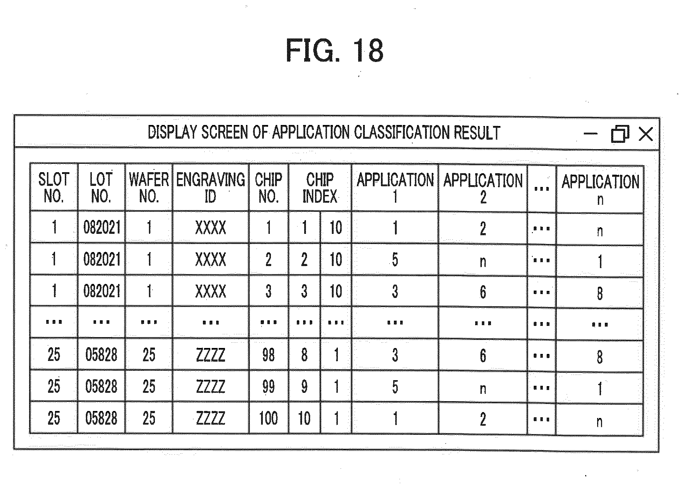

The substrate information 141 concerning the semiconductor substrate includes information data of a slot number, lot number, wafer number, engraving ID, and quality of the substrate. The slot number indicates identification information of the slot within the carrier where the semiconductor substrates are stored. The lot number indicates identification information of the manufacturing process of the semiconductor substrate. The wafer number indicates identification information of the semiconductor substrate. The engraving ID indicates identification information attached to the semiconductor substrate. The information concerning the substrate quality includes an aperture, thickness, impurity concentration of the substrate, and index information representing the good/bad crystal state. The defect inspection result 142 represents the information derived from the inspection device 200, concerning the crystal defect contained in the semiconductor substrate. The three-dimensional defect information 143 represents information of the three-dimensional defect of the semiconductor substrate analyzed by the defect analysis section 111. The example of the structure is described later with reference to Fig. 10. The influence rate of the defect with respect to the device specification is stored as the defect influence rate 144. The example of the structure is described later with reference to Fig. 11. The operation condition of the semiconductor device for each application is recorded as the device operation condition 145. The example of the structure is described later with reference to Fig. 12. The process condition history 146 indicates a process condition to be used during manufacturing of the semiconductor device to be formed using the semiconductor substrate. The defective rate/relief rate 147 includes the defective rate as the probability that the electrical characteristics of the semiconductor device formed on the semiconductor substrate deviate from the desired condition, and the relief rate as the probability that the electrical characteristics satisfy the desired conditions (conforming product) through inactivation of the defective region by changing the manufacturing process subsequent to occurrence of the defect. The matching rate 148 indicates the degree of adaptability of the certain semiconductor substrate (or the chip formed on the semiconductor substrate) to the semiconductor, device for the specific application. The example of the structure is described later with reference to Figs. 13 and 14. The application classification result 149 indicates the result of classification of the semiconductor substrate (or the chip formed on the semiconductor substrate), for example, the order of matching for each application, that is, the order in accordance with the higher matching rate for each application. The example of the structure is described later with reference to Fig. 18. The defect inactivating rate 150 indicates the probability that the electrical characteristics satisfy the desired condition (conforming product) through inactivation of the defective region by changing the manufacturing process subsequent to occurrence of the defect. The example of the structure is described later with reference to Fig. 15.

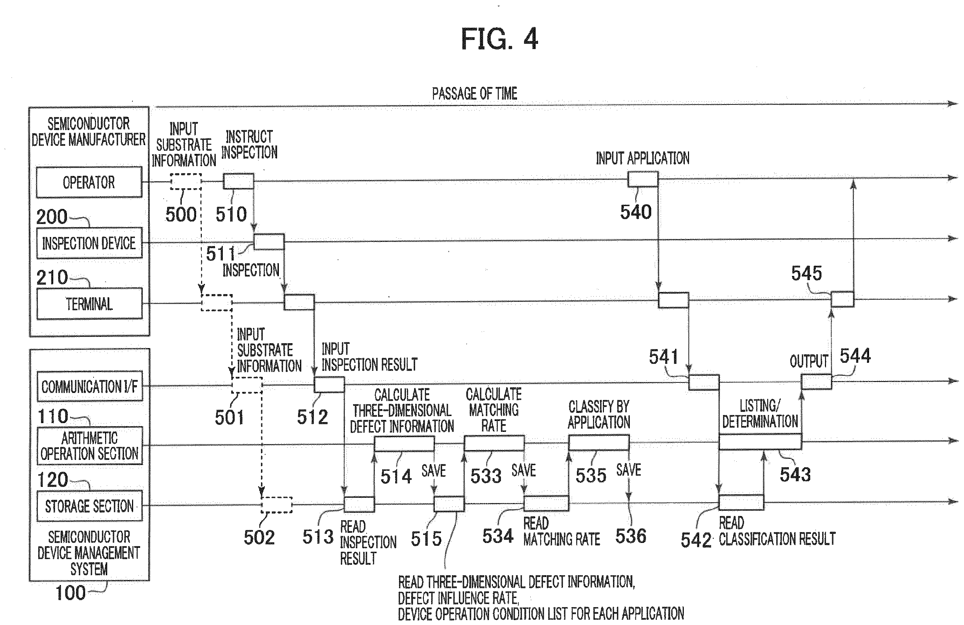

Fig. 4 is a sequence diagram representing processing executed by the semiconductor device management system 100 according to the example. In an example shown in Fig. 4, the semiconductor device management system 100 selects the semiconductor substrate based on the crystal defect inspection result.

An operator of the semiconductor device manufacturer inputs information of the semiconductor substrate into the terminal 210 (500). The semiconductor substrate information input into the terminal 210 is transmitted to the semiconductor device management system 100, and received by the communication interface in the semiconductor device management system 100 (501). The information is then stored in the storage section 120 (502). Operations for inputting and storing the semiconductor substrate information can be omitted.

The operator instructs the inspection device 200 to inspect the semiconductor substrate (510). Following the operator's instruction, the inspection device 200 inspects the semiconductor substrate, and outputs the inspection result to the terminal 210 (511). The terminal 210 transmits the input inspection result and a demand for analyzing the semiconductor substrate to the semiconductor device management system 100. The semiconductor device management system 100 receives the inspection result which has been transmitted from the terminal 210 (512) via the communication interface, and stores the inspection result in the storage section 120 (513). For example, the crystal defect which exists in the semiconductor substrate is inspected.

The arithmetic operation section 110 (defect analysis section 111) of the semiconductor device management system 100 executes the defect analysis program 131 to analyze the three-dimensional defect of the semiconductor substrate demanded for analysis (514) using the inspection result read from the storage section 120. The three-dimensional defect information 143 is stored in the storage section 120 (515).

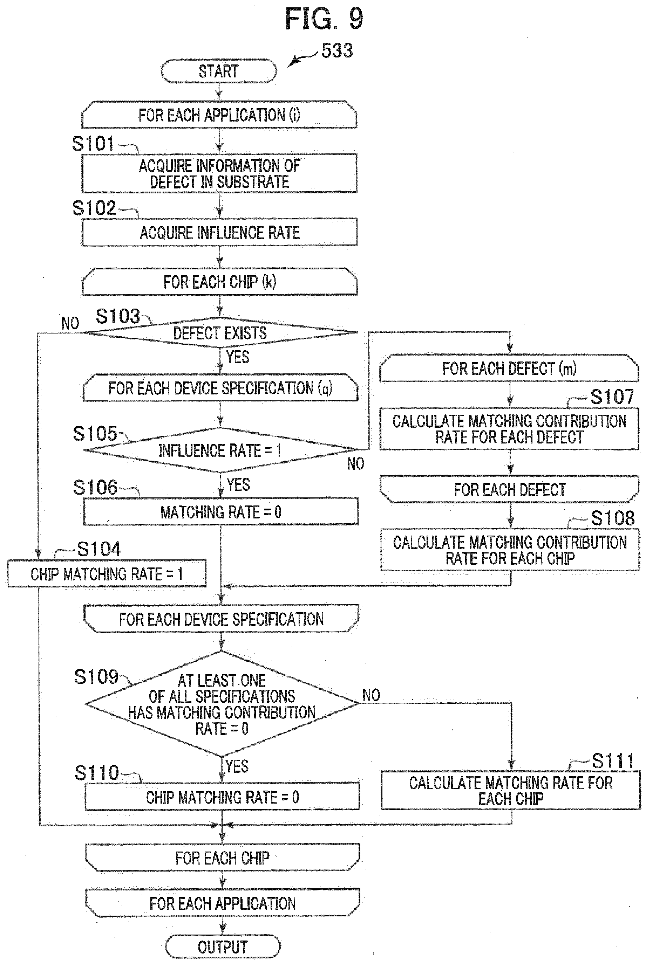

The arithmetic operation section 110 (matching rate calculation section 113) executes the matching rate calculation program 133 to calculate the matching rate 148 for the respective device applications of the semiconductor substrate (533) using the three-dimensional defect information 143 read from the storage section 120, the defect influence.rate 144 as the list of the influence rate of the defect with respect to the device specification, and the device operation condition 145 for each application, and stores the calculation result in the storage section 120 (534). Details of the matching rate calculation process 533 is described later with reference to Fig. 9.

The arithmetic operation section 110 (application classification section 114) executes the application classification program 134 to classify the semiconductor substrate (535) using the matching rate read from the storage section 120, and stores the classification result in the storage section 120 (536).

Meanwhile, the operator inputs the application of the semiconductor device to be manufactured into the terminal 210, and sends a demand for determination of the semiconductor substrate (540). The terminal 210 transmits the demand for classifying the input application of the semiconductor device to the semiconductor device management system 100. The semiconductor device management system 100 receives the semiconductor device application transmitted from the terminal 210 via the communication interface (541), and stores the information in the storage section 120 (542). The semiconductor device application may be input before inputting the information of the semiconductor substrate.

The arithmetic operation section 110 (listing section 115, determination section 116) executes the listing program 135 and the determination program 136 to make a list of the classification results 149 read from the storage section 120, and determines the semiconductor substrate (543). The determination result is output to the terminal 210 via the communication interface.

Upon reception of the determination result, the terminal 210 provides the result to the operator in a manner recognizable by human senses (545).

Referring to the system as shown in Fig. 4, the semiconductor device management system 100 outputs the information for selecting the semiconductor substrate with reference to the three-dimensional defect information 143 derived from the inspection result 142 with respect to the semiconductor substrate defect, the defect influence rate 144 with respect to the device specification, and the device operation condition 145 which differs with the application. It is possible to manufacture the semiconductor device using the semiconductor substrate selected as the one adapted to the device operation condition 145 which differs with the application. This allows provision of the highly reliable semiconductor device at low costs.

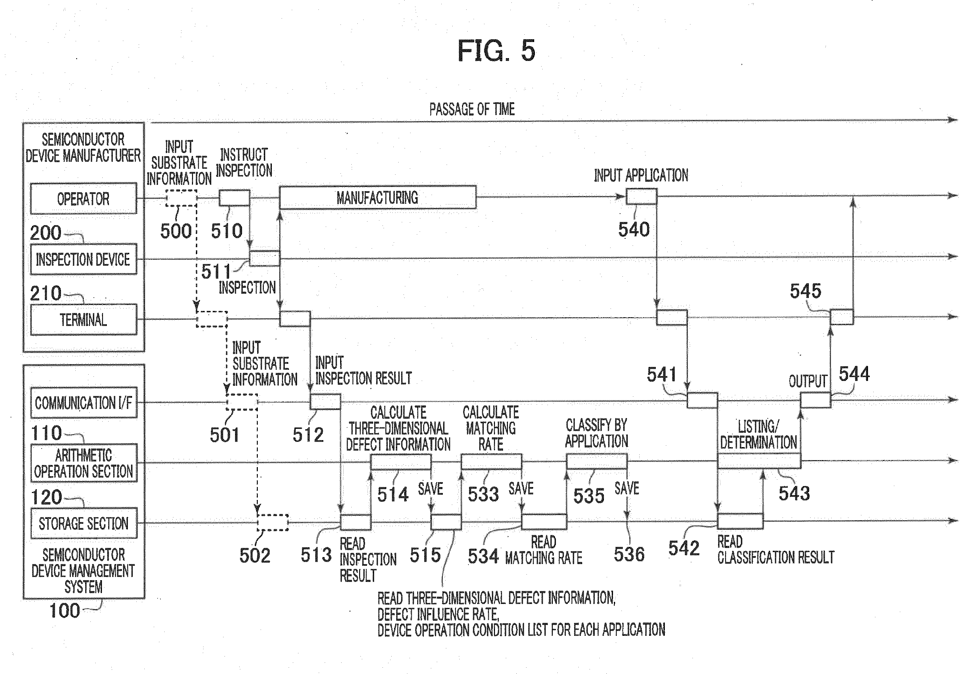

Fig. 5 is a sequence diagram representing processing executed by the semiconductor device management system 100 according to a first modification of the example. In the first modification as shown in Fig. 5, the semiconductor device management system 100 selects the semiconductor device manufactured on the semiconductor substrate based on the crystal defect inspection result.

An operator of the semiconductor device manufacturer inputs information of the semiconductor substrate into the terminal 210 (500). The semiconductor substrate information input into the terminal 210 is transmitted to the semiconductor device management system 100, and received by the communication interface in the semiconductor device management system 100 (501). The information is then stored in the storage section 120 (502). Operations for inputting and storing the semiconductor substrate information can be omitted.

The operator instructs the inspection device 200 to inspect the semiconductor substrate (510). Following the operator's inspection, the inspection device 200 inspects the semiconductor substrate, and outputs the inspection result to the semiconductor manufacturing apparatus 220 and the terminal 210 (511). After the inspection, the semiconductor manufacturing apparatus 220 manufactures the semiconductor device. The terminal 210 transmits the input inspection result and the demand for analysis of the semiconductor substrate to the semiconductor device management system 100. The semiconductor device management system 100 receives the inspection result which has been transmitted from the terminal 210 (512) via the communication interface, and stores the inspection result in the storage section 120 (513). For example, the crystal defect existing in the semiconductor substrate is inspected.

The arithmetic operation section 110 (defect analysis section 111) of the semiconductor device management system 100 executes the defect analysis program 131 to analyze the three-dimensional defect of the semiconductor substrate demanded for analysis (514) using the inspection result read from the storage section 120. The three-dimensional defect information 143 is stored in the storage section 120 (515).

The arithmetic operation section 110 (matching rate calculation section 113) executes the matching rate calculation program 133 to calculate the matching rate 148 for each device application of the chip using the three-dimensional defect information read from the storage section 120, the defect influence rate 144 as the list of the influence rate of the defect with respect to the device specification, and the device operation condition 145 for each application (533) . The calculated result is stored in the storage section 120 (534). Details of the matching rate calculation process 533 is described later with reference to Fig. 9.

The arithmetic operation section 110 (application classification section 114) executes the application classification program 134 to classify the semiconductor device (535) using the matching rate 148 read from the storage section 120. The classification result is stored in the storage section 120 (536).

Meanwhile, after manufacturing the semiconductor device, the operator inputs the application of the manufactured semiconductor device into the terminal 210, and demands determination of the semiconductor device (540). The terminal 210 transmits the demand for classifying the input application of the semiconductor device to the semiconductor device management system 100. The semiconductor device management system 100 receives the semiconductor device application transmitted from the terminal 210 via the communication interface (541), and stores the information in the storage section 120 (542). The semiconductor device application may be input before inputting the information of the semiconductor substrate.

The arithmetic operation section 110 (listing section 115, determination section 116) executes the listing program 135 and the determination program 136 to make a list of the classification result 149 read from the storage section 120, and determines the semiconductor device manufactured on the semiconductor substrate (543). The determination result is output to the terminal 210 via the communication interface (544) .

Upon reception of the determination result, the terminal 210 provides the result to the operator in a manner recognizable by human senses (545).

In the first modification as shown in Fig. 5, the semiconductor device management system 100 outputs the information for selecting the semiconductor device to be formed on the semiconductor substrate with reference to the three-dimensional defect information 143 derived from the inspection result 142 with respect to the defect of the semiconductor substrate, the defect influence rate 144 with respect to the device specification, and the device operation condition 145 which differs with the application. This makes it possible to selectively ship the semiconductor device manufactured at an inner position of the substrate which is adapted to the device operation condition 145 that differs with the application, and further to provide the highly reliable semiconductor device at low costs.

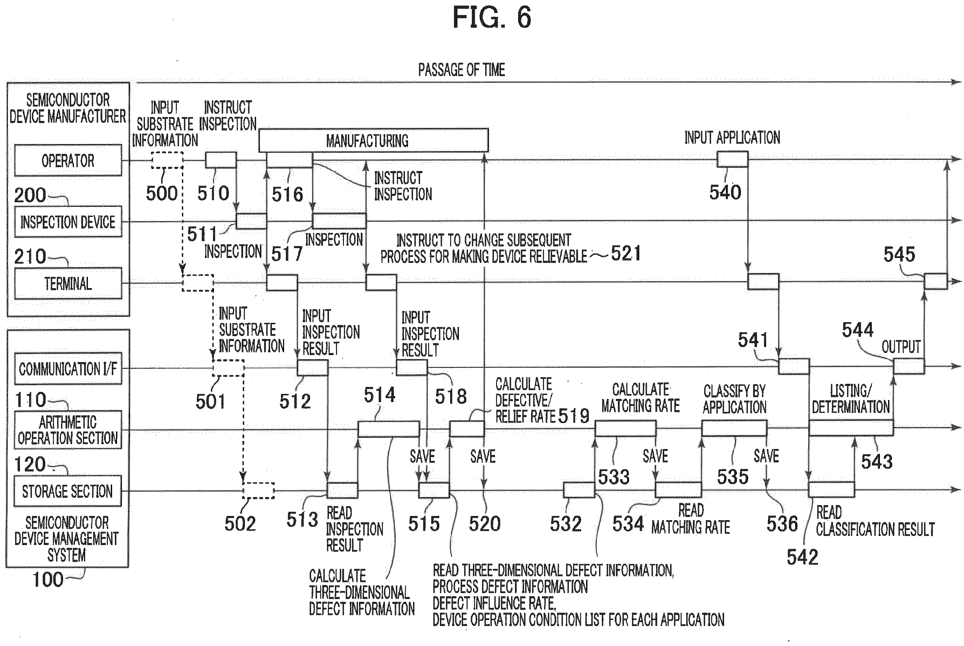

Fig. 6 is a sequence diagram representing processing executed by the semiconductor device management system 100 according to a second modification of the example. In a second modification as shown in Fig. 6, based on the crystal defect inspection result, and the process defect which has occurred in the process for manufacturing the semiconductor device, the semiconductor device management system 100 selects the manufactured semiconductor device.

An operator of the semiconductor device manufacturer inputs information of the semiconductor substrate into the terminal 210 (500). The semiconductor substrate information input into the terminal 210 is transmitted to the semiconductor device management system 100, and received by the communication interface in the semiconductor device management system 100 (501) . The information is then stored in the storage section 120 (502). Operations for inputting and storing the semiconductor substrate information can be omitted.

The operator instructs the inspection device 200 to inspect the semiconductor substrate (510). Following the operator's inspection, the inspection device 200 inspects the semiconductor substrate, and outputs the inspection result to the semiconductor manufacturing apparatus 220 and the terminal 210 (511). After the inspection, the semiconductor manufacturing apparatus 220 manufactures the semiconductor device. The terminal 210 transmits the input inspection result and the demand for analysis of the semiconductor substrate to the semiconductor device management system 100. The semiconductor device management system 100 receives the inspection result which has been transmitted from the terminal 210 (512) via the communication interface, and stores the inspection result in the storage section 120 (513). For example, the crystal defect existing in the semiconductor substrate is inspected.

The arithmetic operation section 110 (defect analysis section 111) of the semiconductor device management system 100 executes the defect analysis program 131 to analyze the three-dimensional defect of the semiconductor substrate demanded for analysis (514) using the inspection result read from the storage section 120. The three-dimensional defect information 143 is stored in the storage section 120 (515).

In the process of manufacturing the semiconductor device, following the operator's instruction (516), the inspection device 200 inspects the semiconductor substrate, and outputs the inspection result to the semiconductor manufacturing apparatus 220 and the terminal 210 (517). Based on the inspection result, the semiconductor manufacturing apparatus 220 adjusts the subsequent process, and continues execution of the semiconductor device manufacturing process. The terminal 210 transmits the input inspection result and the demand for analysis of the semiconductor substrate to the semiconductor device management system 100. The semiconductor device management system 100 receives the inspection result transmitted from the terminal 210 via the communication interface (518), and stores the inspection result in the storage section 120 (515). For example, upon the inspection process, the process defect such as the patterning failure which has occurred in the semiconductor substrate is inspected.

The arithmetic operation section 110 (defective/relief rate calculation section 112) executes the defective/relief rate calculation program 132 to calculate the probability (defective rate) that the electrical characteristics of the semiconductor device to be formed on the semiconductor substrate deviate from the desired conditions, and the probability (relief rate) that the electrical characteristics satisfy the desired condition (conforming product) through inactivation of the defect region by changing the manufacturing process subsequent to occurrence of the defect for each device application using the three-dimensional defect information read from the storage section 120, the process defect information, the defect influence rate 144 as the list of the influence rate of the defect with respect to the device specification, and the device operation condition 145 for each application (519). The calculation results are stored in the storage section 120 (520) .

The process defect may be relieved by changing the subsequent process depending on the type, level, and position of the defect. In the case of the chip having both the defective rate and the relief rate greater than the predetermined threshold values, respectively, the semiconductor device management system 100 instructs the semiconductor manufacturing apparatus 220 to change the subsequent process to allow the semiconductor device to be manufactured to attain the desired characteristics (521).

Following the operator's instruction (516), in the main manufacturing process, the semiconductor substrate is inspected, and the inspection result is output to the semiconductor manufacturing apparatus 220 and the terminal 210 (517). The semiconductor device management system 100 receives the result via the communication interface (518), stores the information in the storage section 120 (515), calculates the defective rate and the relief rate for each device application. (519), stores the calculation results in the storage section 120 (520), and instructs the semiconductor manufacturing apparatus 220 to change the subsequent process based on the calculation results (521). The above-described processes are executed repeatedly.

Following the operator's instruction (516), in the last main process, the semiconductor substrate is inspected, and the inspection result is output to the semiconductor manufacturing apparatus 220 and the terminal 210 (517). The semiconductor device management system 100 receives the result via the communication interface (518), and stores the information in the storage section 120 (515). Inspection operations in the last main process can be omitted.

The arithmetic operation section 110 (matching rate calculation section 113) executes the matching rate calculation program 133 to calculate the matching rate 148 of the chip for each device application (533) using the three-dimensional defect information 143 read from the storage section 120, the process defect information, the influence rate 144 of the defect with respect to the device specification, and the device operation condition 145 for each application. The calculation results are stored in the storage section 120 (534). Details of the matching rate calculation process 533 is described later with reference to Fig. 9.

The arithmetic operation section 110 (application classification section 114) executes the application classification program 134 to classify the semiconductor device (535) using the matching rate 148 read from the storage section 120. The classification result is stored in the storage section 120 (536).

Meanwhile, after manufacturing the semiconductor device, the operator inputs the application of the manufactured semiconductor device into the terminal 210, and demands determination of the semiconductor device (540). The terminal 210 transmits the demand for classifying the input application of the semiconductor device to the semiconductor device management system 100. The semiconductor device management system 100 receives the semiconductor device application transmitted from the terminal 210 via the communication interface (541), and stores the information in the storage section 120 (542). The semiconductor device application may be input before inputting the information of the semiconductor substrate.

The arithmetic operation section 110 (listing section 115, determination section 116) executes the listing program 135 and the determination program 136 to make a list of the classification result 149 read from the storage section 120, and determines the semiconductor device manufactured on the semiconductor substrate (543). The determination result is output to the terminal 210 via the communication interface (544) .

Upon reception of the determination result, the terminal 210 provides the result to the operator in a manner recognizable by human senses (545).

In the second modification as shown in Fig. 6, the semiconductor device management system 100 calculates the defective rate and the relief rate for each device application with reference to the three-dimensional defect information 143 derived from the semiconductor substrate defect inspection result 142, the information of the process defect which has occurred in the course of semiconductor device manufacturing, the defect influence rate 144 with respect to the device specification, and the device operation condition 145 which differs with the application, and determines the semiconductor device that can be relieved by changing the subsequent process. The subsequent process is changed according to the determination result so that the process defect is inactivated to improve manufacturing yields. Additionally, with reference to the three-dimensional defect information 143, the information of the process defect which has occurred in the course of semiconductor device manufacturing, the defect influence rate 144 with respect to the device specification, and the device operation condition 145 which differs with the application, the semiconductor device management system 100 outputs the information for selection of the semiconductor device to be formed on the semiconductor substrate. This makes it possible to selectively ship the semiconductor device manufactured at the inner position of the substrate which is adapted to the device operation condition 145 that differs with the application, and further to provide the highly reliable semiconductor device at low costs.

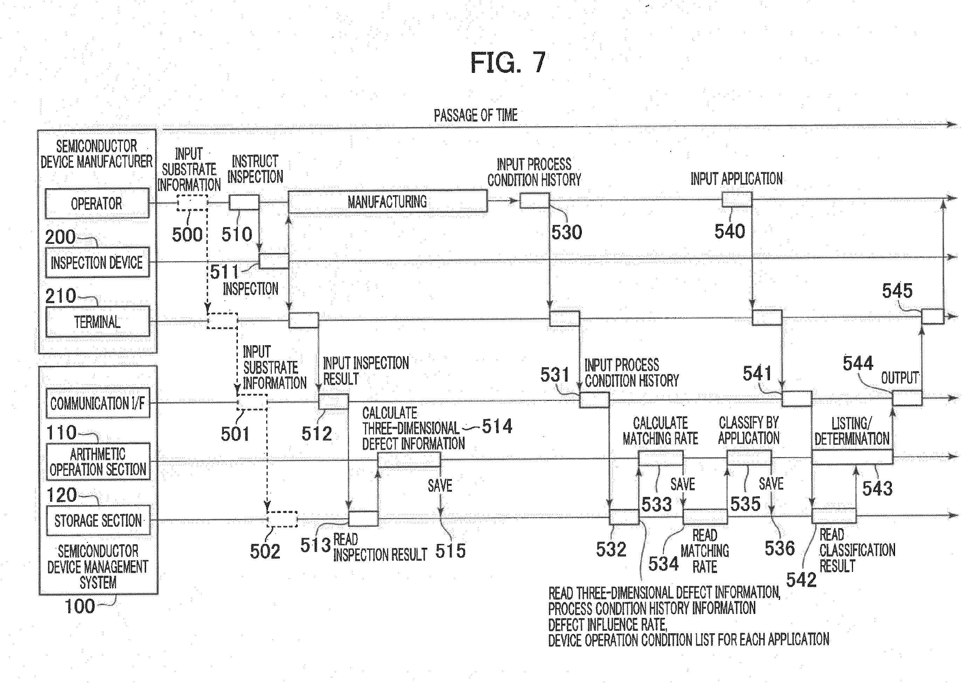

Fig. 7 is a sequence diagram representing processing executed by the semiconductor device management system 100 according to a third modification of the example. In a third modification as shown in Fig. 7, based on the crystal defect inspection result, and the process condition history 146 in the semiconductor device manufacturing, the semiconductor device management system 100 selects the manufactured semiconductor device.

An operator of the semiconductor device manufacturer inputs information of the semiconductor substrate into the terminal 210 (500). The semiconductor substrate information input into the terminal 210 is transmitted to the semiconductor device management system 100, and received by the communication interface in the semiconductor device management system 100 (501). The information is then stored in the storage section 120 (502). Operations for inputting and storing the semiconductor substrate information can be omitted.

The operator instructs the inspection device 200 to inspect the semiconductor substrate (510). Following the operator's inspection, the inspection device 200 inspects the semiconductor substrate, and outputs the inspection result to the semiconductor manufacturing apparatus 220 and the terminal 210 (511). The semiconductor manufacturing apparatus 220 manufactures the semiconductor device according to the inspection results input by the operator. The terminal 210 transmits the input inspection result and the demand for analysis of the semiconductor substrate to the semiconductor device management system 100. The semiconductor device management system 100 receives the inspection result which has been transmitted from the terminal 210 (512) via the communication interface; and stores the inspection result in the storage section 120 (513). For example, the crystal defect existing in the semiconductor substrate is inspected.

The arithmetic operation section 110 (defect analysis section 111) of the semiconductor device management system 100 executes the defect analysis program 131 to analyze the three-dimensional defect of the semiconductor substrate demanded for analysis (514) using the inspection result read from the storage section 120. The three-dimensional.defect information 143 is stored in the storage section 120 (515).

After manufacturing the semiconductor device, the operator inputs the process condition history 146 of the semiconductor device into the terminal 210 to demand classification of the semiconductor device (530). The terminal 210 transmits the required application to the input semiconductor device, and the demand for classification of the semiconductor substrate to the semiconductor device management system 100. The semiconductor device management system 100 receives the process condition history 146 transmitted from the terminal 210 via the communication interface (531), and stores the information in the storage section 120 (532).

The arithmetic operation section 110 (matching rate calculation section 113) executes the matching rate calculation program 133 to calculate the matching rate 148 of the chip for each device application using the three-dimensional defect information read from the storage section 120, the process condition history 146, the defect influence rate 144 as the list of the influence rate of the defect with respect to the device specification, and the device operation condition 145 for each application (533), and stores the calculation results in the storage section 120 (534). Details of the matching rate calculation process 533 is described later with reference to Fig. 9.

The arithmetic operation section 110 (application classification section 114) executes the application classification program 134 to classify the semiconductor device (535) using the matching rate 148 read from the storage section 120. The classification result is stored in the storage section 120 (536).

Meanwhile, after manufacturing the semiconductor device, the operator inputs the application of the manufactured semiconductor device into the terminal 210, and demands determination of the semiconductor device (540). The terminal 210 transmits the demand for classifying the input application of the semiconductor device to the semiconductor device management system 100. The semiconductor device management system 100 receives the semiconductor device application transmitted from the terminal 210 via the communication interface (541), and stores the information in the storage section 120 (542). The semiconductor device application may be input before inputting the information of the semiconductor substrate.

The arithmetic operation section 110 (listing section 115, determination section 116) executes the listing program 135 and the determination program 136 to make a list of the classification result 149 read from the storage section 120, and determines the semiconductor device manufactured on the semiconductor substrate (543). The determination result is output to the terminal 210 via the communication interface (544).

Upon reception of the determination result, the terminal 210 provides the result to the operator in a manner recognizable by human senses (545).

In the second modification as shown in Fig. 7, the semiconductor device management system 100 outputs the information for selection of the semiconductor device to be formed on the semiconductor substrate with reference to the three-dimensional defect information 143 derived from the inspection result 142 of the semiconductor substrate defect, the process condition history 146 of the semiconductor device, the defect influence rate 144 with respect to the device specification, and the device operation condition 145 which differs with the application. Existence of a material quality distribution in the substrate may vary the material quality with the process condition history. In the second modification, considering the information of the material quality which varies with the process condition history, it is possible to selectively ship the semiconductor device manufactured at the inner position of the substrate adapted to the device operation condition 145 which differs with the application. This makes it possible to provide the highly reliable semiconductor device at low costs.

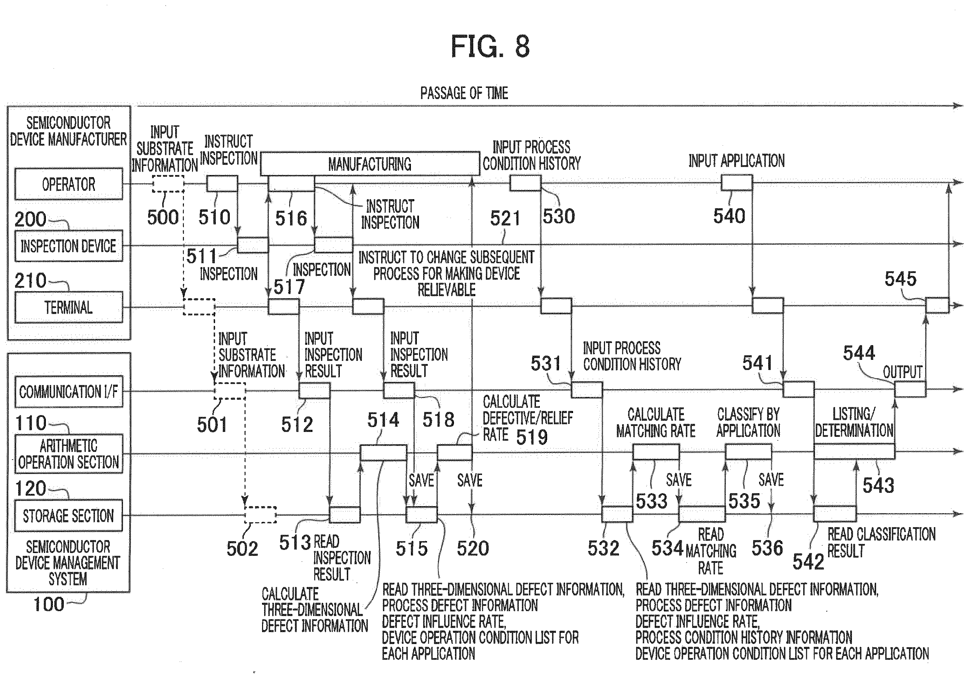

Fig. 8 is a sequence diagram representing processing executed by the semiconductor device management system 100 according to a fourth modification of the example. In a fourth modification as shown in Fig. 8, the semiconductor device management system 100 selects the manufactured semiconductor device based on the crystal defect inspection result, the process defect which has occurred in the course of manufacturing the semiconductor device, and the process condition history 146 in manufacturing of the semiconductor device.

An operator of the semiconductor device manufacturer inputs information of the semiconductor substrate into the terminal 210 (500). The semiconductor substrate information input into the terminal 210 is transmitted to the semiconductor device management system 100, and received by the communication interface in the semiconductor device management system 100 (501). The information is then stored in the storage section 120 (502). Operations for inputting and storing the semiconductor substrate information can be omitted.

The operator instructs the inspection device 200 to inspect the semiconductor substrate (510). Following the operator's inspection, the inspection device 200 inspects the semiconductor substrate, and outputs the inspection result to the semiconductor manufacturing apparatus 220 and the terminal 210 (511). After the inspection, the semiconductor manufacturing apparatus 220 manufactures the semiconductor device. The terminal 210 transmits the input inspection result and the demand for analysis of the semiconductor substrate to the semiconductor device management system .100. The semiconductor device management system 100 receives the inspection result which has been transmitted from the terminal 210 (512) via the communication interface, and stores the inspection result in the storage section 120 (513). For example, the crystal defect existing in the semiconductor substrate is inspected.

The arithmetic operation section 110 (defect analysis section 111) of the semiconductor device management system 100 executes the defect analysis program 131 to analyze the three-dimensional defect of the semiconductor substrate demanded for analysis (514) using the inspection result read from the storage section 120. The three-dimensional defect information 143 is stored in the storage section 120 (515).

In the process of manufacturing the semiconductor device, following the operator's instruction (516), the inspection device 200 inspects the semiconductor substrate, and outputs the inspection result to the semiconductor manufacturing apparatus 220 and the terminal 210 (517). Based on the inspection result, the semiconductor manufacturing apparatus 220 adjusts the subsequent process, and continues execution of the semiconductor device manufacturing process. The terminal 210 transmits the input inspection result and the demand for analysis of the semiconductor substrate to the semiconductor device management system 100. The semiconductor device management system 100 receives the inspection result transmitted from the terminal 210 via the communication interface (518), and stores the inspection result in the storage section 120 (515). For example, upon the inspection process, the process defect such as the patterning failure which has occurred in the semiconductor substrate is inspected.

The arithmetic operation section 110 (defective/relief rate calculation section 112) executes the defective/relief rate calculation program 132 to calculate the probability (defective rate) that electrical characteristics of the semiconductor device to be formed on the semiconductor substrate deviate from the desired condition, and the probability (relief rate) that electrical characteristics satisfy the desired condition (conforming product) through inactivation of the defect region by changing the manufacturing process subsequent to occurrence of the defect using the three-dimensional defect information 143 read from the storage section 120, the process defect information, the defect influence rate 144 as the list of the influence rate of the defect with respect to the device specification, and the application device operation condition 145 (519). The calculation results are stored in the storage section 120 (520) .

The process defect may be relieved by changing the subsequent process depending on the type, level, and position of the defect. In the case of the chip having both the defective rate and the relief rate greater than the predetermined threshold values, respectively, the semiconductor device management system 100 instructs the semiconductor manufacturing apparatus 220 to change the subsequent process to allow the semiconductor device to be manufactured to attain the desired characteristics (521).

Following the operator's instruction (516), in the main manufacturing process, the semiconductor substrate is inspected, and the inspection result is output to the semiconductor manufacturing apparatus 220 and the terminal 210 (517). The semiconductor device management system 100 receives the result via the communication interface (518), stores the information in the storage section 120 (515), calculates the defective rate and the relief rate for each device application (519), stores the calculation results in the storage section 120 (520), and instructs the semiconductor manufacturing apparatus 220 to change the subsequent process based on the calculation results (521). The above-described processes are executed repeatedly.

Following the operator's instruction (516), in the last main process, the semiconductor substrate is inspected, and the inspection result is output to the semiconductor manufacturing apparatus 220 and the terminal 210 (517). The semiconductor device management system 100 receives the result via the communication interface (518), and stores the information in the storage section 120 (515). Inspection operations in the last main process can be omitted.

After manufacturing the semiconductor device, the operator inputs the process condition history 146 of the semiconductor device into the terminal 210 to demand classification of the semiconductor device (530). The terminal 210 transmits the input demand for classification of the semiconductor device to the semiconductor device management system 100. The semiconductor device management system 100 receives the process condition history 146 transmitted from the terminal 210 via the communication interface (531), and stores the information in the storage section 120 (532).

The arithmetic operation section 110 (matching rate calculation section 113) executes the matching rate calculation program 133 to calculate the matching rate 148 of the chip for each device application (533) using the three-dimensional defect information 143 read from the storage section 120, the process defect information, the defect influence rate 144 as the list of the influence rate of the defect with respect to the device specification, the process condition history 146, and the application device operation condition 145. The calculation results are stored in the storage section 120 (534). Details of the matching rate calculation process 533 is described later with reference to Fig. 9.

The arithmetic operation section 110 (application classification section 114) executes the application classification program 134 to classify the semiconductor device (535) using the matching rate 148 read from the storage section 120. The classification result is stored in the storage section 120 (536).

Meanwhile, after manufacturing the semiconductor device, the operator inputs the application of the manufactured semiconductor device into the terminal 210, and demands determination of the semiconductor device (540). The terminal 210 transmits the demand for classifying the input application of the semiconductor device to the semiconductor device management system 100. The semiconductor device management system 100 receives the semiconductor device application transmitted from the terminal 210 via the communication interface (541), and stores the information in the storage section 120 (542). The semiconductor device application may be input before inputting the information of the semiconductor substrate.

The arithmetic operation section 110 (listing section 115, determination section 116) executes the listing program 135 and the determination program 136 to make a list of the classification result 149 read from the storage section 120, and determines the semiconductor device manufactured on the semiconductor substrate (543). The determination result is output to the terminal 210 via the communication interface (544) .

Upon reception of the determination result, the terminal 210 provides the result to the operator in a manner recognizable by human senses (545).

In the fourth modification as shown in Fig. 8, the semiconductor device management system 100 calculates the defective rate and the relief rate for each-device application with reference to the three-dimensional defect information 143 derived from the defect inspection result 142 of the semiconductor substrate, the information of the process defect which has occurred in the course of manufacturing the semiconductor device, the defect influence rate 144 with respect to the device specification, and the device operation condition 145 which differs with the application. The semiconductor device which can be relieved by changing the subsequent process is determined. The subsequent process is changed according to the determination result so that the process defect is inactivated to improve manufacturing yields. Additionally, the semiconductor device management system 100 outputs the information for selection of the semiconductor device to be formed on the semiconductor substrate with reference to the three-dimensional defect information 143 of the semiconductor substrate, the information of the process defect which has occurred in the course of manufacturing the semiconductor device, the defect influence rate 144 with respect to the device specification, the process condition history 146, and the device operation condition 145 which differs with the application. In the fourth modification, considering the information of the material quality which varies with the process condition history, it is possible to selectively ship the semiconductor device manufactured at the inner position of the substrate adapted to the device operation condition 145 which differs with the application. This makes it possible to provide the highly reliable semiconductor device at low costs.

Fig. 9 is a flowchart of the matching rate calculation process 533.

The matching rate calculation section 113 (matching rate calculation program 133) of the semiconductor device management system 100 executes the arithmetic operations subsequent to step S101 repeatedly for each semiconductor device application until completion of arithmetic operations for all applications.

The matching rate calculation section 113 acquires, from the three-dimensional defect information 143, information of the three-dimensional defect of the semiconductor substrate, which has been analyzed by the defect analysis section 111 (S101). It is possible for the three-dimensional defect information 143 to be acquired to include the defect position in the semiconductor substrate (three-dimensional coordinates), defect type, defect shape, defect size (width, longitudinal length, area), the type of device to be manufactured on the semiconductor substrate, and the position of the defect in the chip.

The matching rate calculation section 113 acquires the influence rate of the defect with respect to each of the device specifications from the defect influence rate 144 (S102).

The matching rate calculation section 113 executes arithmetic operations from step S103 to step Sill for each chip repeatedly until completion of the arithmetic operations for all chips.

The matching rate calculation section 113 determines whether the defect exists in the chip (S103). If the chip contains no defect, the chip characteristic is not deteriorated by the defect. The chip matching rate is then set to 1 (S104). Meanwhile, if the chip contains the defect, the matching rate calculation section 113 executes arithmetic operations from step S105 to step S108 for each device specification repeatedly until completion of the arithmetic operations executed for all the device specifications.

The matching rate calculation section 113 determines whether the influence rate with respect to the device specification is 1 (S105). If the influence rate with respect to the device specification is 1, it means that the defect significantly influences the device specification, and accordingly, it is impossible to apply the chip to the device specification. The matching rate to the device specification is set to 0 (S106).

Meanwhile, if the influence rate with respect to the device specification is not 1, a matching contribution rate indicating the degree of influence on the device specification is calculated for each defect (S107). For example, assuming that the matching contribution rate is expressed by "1 - influence rate", the matching contribution rate can be obtained by the following formula: MRi_k_q_m = 1 - (influence rate given to the device specification q × (area of defect ÷ area of chip)}, where i denotes the application, k denotes the chip number, q denotes the device specification, and m denotes the defect.

After calculating the matching contribution rates for all the defects, the matching rate calculation section 113 calculates the matching contribution rate for each chip (S108) . For example, the matching contribution rate MRi_k_q to the device specification q of the chip with the chip number k for the application i becomes a statistic value of the matching contribution rates from MRi_k_q_1 to MRi_k_q_M of all the defects (defect m = 1 to M), which have been calculated in step 5107. It is possible to use the mean value, median, most frequent value, and weighted mean for the statistic value.

After calculating the matching contribution rates for all the device specifications, the matching rate calculation section 113 determines whether there is the specification having the matching contribution rate set to 0 among those for all the device specifications (S109). If there is at least one device specification which has the matching contribution rate set to 0, the chip matching rate is set to 0 (S110). If there is no device specification having the matching contribution rate set to 0 among those for all the device specifications, the matching rate for each chip is calculated (S111). For example, the matching rate MRi_k of the chip with the chip number k for the application i is the statistic value of the matching contribution rates from MRi_k_ 1 to MRi_k_Q for all the device specifications (specification q = 1 to Q) of the chip with chip number k, which have been calculated in step S108. It is possible to use the mean value, median, most frequent value, and weighted mean for the statistic value.

After calculating the matching rates of all the chips for all the applications, the matching rate calculation section 113 terminates the matching rate calculation process 533.

The matching rate 148 calculated by the matching rate calculation process 533 is transmitted to the application classification section 114 where the application having the maximum matching rate for each of all the chip numbers (most adaptable) is classified into the first application.

As described above, the matching rate calculation section 113 receives inputs of the three-dimensional defect information 143 of the semiconductor substrate (Fig. 10), the defect influence rate 144 with respect to the device specification (Fig. 11), and the device operation condition 145 for each application (Fig. 12), and outputs the matching rate MR for each device application of the semiconductor substrate or the chip.

Fig. 10 shows an example of a structure of the three-dimensional defect information 143 input into the matching rate calculation section 113 in a table form.

The three-dimensional defect information 143 records the information of crystal defects of the semiconductor substrate. The information includes the slot No., engraving ID, defect ID, center coordinates, defect type, width, longitudinal length, and area. The slot number indicates identification information of the slot within the carrier where the semiconductor substrates are stored. The engraving ID indicates identification information attached to the semiconductor substrate. The defect ID indicates the identification information of the crystal defect found in the semiconductor substrate. The center coordinates indicate the coordinates of the center position of the defect, which are expressed using x, y, z while having the center of the semiconductor substrate surface as the origin. The defect type indicates the identification information of the defect type, which includes, for example, a bunching step, stacking fault complex, scratch scar, micropipe, stacking fault, basal plane dislocation, and surface particle. The width and the longitudinal length indicate the size of the defect in x and y directions of the semiconductor substrates, respectively. The area indicates an area of the defect.

Fig. 11 shows an example of a structure of the defect influence rate 144 input into the matching rate calculation section 113 in a table form.

The defect influence rate 144 records the influence rate indicating the influence of the defect on the device application. The information includes the defect type, width, longitudinal length, area, device type No., position in the chip, and the influence rate for each device specification. The defect type indicates the identification information of the defect for each type. The width and the longitudinal length indicate the size of the defect in x and y directions of the semiconductor substrates, respectively. The area indicates an area of the defect. The device type No. indicates the identification information of the semiconductor device for each type, including, for example, the diode, MOS, and IGBT. The position in the chip indicates the identification information of the position of the defect in the chip, including, for example, a terminal end region, contact region, and outside the operation region. The influence rate is specified for each device specification, taking the value ranging from 0 to 1. As the influence rate becomes higher, the degree of deterioration in the semiconductor device characteristics increases (for example, the influence rate of 1 makes the semiconductor device 100% defective). The influence rate normally takes the value which differs with the factory.

Fig. 12 shows an example of a structure of the device operation condition 145 input into the matching rate calculation section 113 in a table form.

The device operation condition 145 records the device specification and the design diagram information for each application. The information includes the application No., device type No., device specification, and position of the terminal end region of each chip. The specification of the semiconductor device differs with the target to which such device is applied, that is, the application. The design diagram may be determined in accordance with the specification of the semiconductor device. Accordingly, the design diagram information may be included in the device operation condition 145. The design diagram information indicates the coordinate list representing the correspondence of the region in the wafer to the position in the chip (operation region, non-operation region). The design diagram information allows determination whether the defect of the semiconductor substrate is within the operation region or the non-operation region of the chip. The application No. indicates the identification information of the semiconductor device application, which includes the industrial equipment, automobiles, and trains. The device type No. indicates the identification information of the semiconductor device for each type, which includes the diode, MOS, and IGBT. The device specification indicates the one for electrical characteristics of the semiconductor device, which includes the rated voltage, rated current, resistance, operation lower limit temperature, operation upper limit temperature, ON voltage, gate lower limit voltage, gate upper-limit voltage, threshold voltage, gate source leakage current, gate resistance, input capacity, output capacity, and feedback capacitance. The terminal end regions of the respective chips indicate coordinate lists representing the design diagram information.

Each of Fig. 13 and Fig. 14 shows an example of a structure of the matching rate 148 output from the matching rate calculation section 113 in a table form.

An example of the matching rate 148 as shown in Fig. 13 indicates the matching rate of the semiconductor substrate for each device application, and includes the slot No., engraving ID, and matching rate for each application. The slot No. is the information common to the three-dimensional defect information 143 (Fig. 10). The engraving ID indicates the identification information attached to the semiconductor substrate like the three-dimensional defect information 143. As described above, the matching rate is an index indicating the degree of adaptability of the semiconductor substrate with the slot No. to the semiconductor device for each application, taking the value ranging from 0 to 1. The matching rate of 0 indicates no adaptability.

An example of the matching rate 148 as shown in Fig. 14 indicates the matching rate of the semiconductor chip for each device application, and includes the slot No., lot No., wafer No., engraving ID, chip No., chip index, and matching rate for each application. The information including the slot No. and the engraving ID is common to the three-dimensional defect information 143 (Fig. 10). The lot number indicates identification information of the manufacturing process of the semiconductor substrate. The wafer number indicates identification information of the semiconductor substrate. The chip No. indicates the identification information of the semiconductor chip to be manufactured on the semiconductor substrate. The chip index indicates the information of the position in the case which stores the semiconductor chip cut from the semiconductor wafer after manufacturing. As described above, the matching rate is an index indicating the degree of adaptability of the semiconductor chip manufactured on the semiconductor substrate with the slot No. to the semiconductor device for each application, taking the value ranging from 0 to 1. The matching rate of 0 indicates no adaptability.

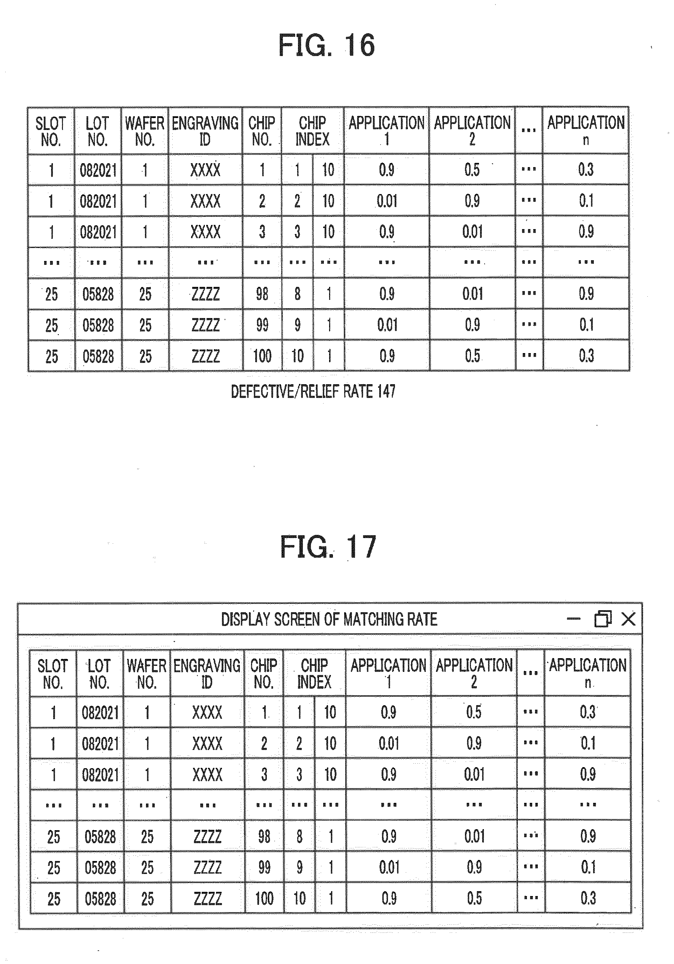

The matching rate 148 is displayed in the table form on a matching rate display screen, as shown in Fig. 17.

As described above, the defective/relief rate calculation section 112 receives inputs of the three-dimensional defect information 143, the process defect information, the influence rate 144 of the defect with respect to the device specification (or the list of the defect inactivating rate as shown in Fig. 15), and the device operation condition 145 for each application, and outputs the defective rate and the relief rate.

Whether the chip having at least one of the crystal defect or the process defect becomes an electrically conforming product depends on the defect type, the shape information such as size, the device type, the position in the chip, and the device operation condition for each application. The influence rate 144 of the defect with respect to the device specification records the possibility (influence rate) that the chip becomes an electrically defective product owing to the crystal defect and the process defect. Although there is a high possibility that the chip containing the crystal defect or the process defect therein becomes the defective product, the defect may be inactivated in the subsequent process step depending on the defect type, shape information such as size, device type, position in the chip, process having the defect occurred, and device operation condition for each application. The list of the defect inactivating rate records the probability that the electrical characteristics attain the desired condition (conforming product) through inactivation of the defect region by changing the manufacturing process subsequent to occurrence of the defect.

Fig. 15 shows an example of a structure of the defect inactivating rate 150 to be input into the defective/relief rate calculation section 112. The defect inactivating rate 150 records the probability that the defect region is inactivated by the subsequent process for each defect,, and includes the defect type, width, longitudinal length, area, device type No., position in the chip, application No., category No. of the process having the defect occurred, and inactivating rate. The information including the defect type, width, longitudinal length, and area is common to the three-dimensional defect information 143 (Fig. 10). The information including the device type No. and position in the chip is common to the defect influence rate 144 (Fig. 11). The information of the application No. is common to the device operation condition 145 (Fig. 12). The category No. of the process having the defect occurred indicates the identification information for each type of the process having the defect occurred, and includes processes of cleaning before trial manufacturing, marking for alignment, implanting ion into the terminal end region, implanting ion into the contact region, implanting ion into the reverse surface, activating annealing, sacrificial oxidization, gate oxide film formation, and protective film formation. The inactivating rate indicates the probability that the defect of the corresponding defect type is inactivated in the subsequent process.

Fig. 16 shows an example of a structure of the defective rate and the relief rate to be output from the defective/relief rate calculation section 112 in a table form. The defective rate and the relief rate indicate the probability that the chip including at least one of the crystal defect or the process defect becomes an electrically defective product, and the probability that the chip including at least one of the crystal defect or the process defect has its electrical characteristics attaining the desired condition (conforming product) by changing the manufacturing process subsequent to occurrence of the defect. Each of the defective rate and the relief rate is obtained for each chip and each application, and includes the slot No., lot No., wafer No., engraving ID, chip No., and chip index. The slot No. is the information common to the three-dimensional defect information 143 (Fig. 10). The information including the lot No., wafer No., engraving ID, chip No., and chip index is common to the matching rate 148 (Fig. 14).

Fig. 18 shows an example of a display screen of the application classification results displaying results output from the application classification section 114.

The semiconductor device management system 100 of the example displays the order of applications to which the chip on the semiconductor substrate is adapted by comparison performed by the determination section 116 between the classification result 149 of the semiconductor device manufactured on the semiconductor substrate, and the input application. The display screen of the application classification results displays the classification results 149 such as the slot No., lot No., wafer No., engraving ID, chip No., chip index, and adaptability to the application. The slot No. is the information common to the three-dimensional defect information 143 (Fig. 10). The information including the lot No., wafer No., engraving ID, chip No., and chip index is common to the matching rate 148 (Fig. 14). In the column of application, the order of application adaptability, that is, the order of high matching rate is displayed. In the example as shown in the drawing, the numerical value 1 indicates the highest adaptability, and n indicates the lowest adaptability.

As described above, the semiconductor device management system 100 according to the example is configured to have the arithmetic operation section 110 provided with the adaptability calculation section (matching rate calculation section 113) for calculating adaptability of the semiconductor substrate for each device application using the three-dimensional position information (three-dimensional defect information 143) of the crystal defect contained in the semiconductor substrate, the influence rate (defect influence rate 144) of the defect with respect to the device specification, and the operation condition 145 of the semiconductor device for each application, and the determination section 116 for determining the application to the semiconductor substrate basedon the adaptability so that data for outputting at least the determined application are generated. This makes it possible to output the information for selection of the semiconductor device to be formed on the semiconductor substrate from the inspection result 142 of the semiconductor substrate defect with reference to the influence rate (defect influence rate 144) of the defect with respect to the device specification, and the device operationcondition 145 which differs with the application. It is possible to selectively ship the semiconductor device manufactured at the inner position of the substrate, which is adapted to the device operation condition 145 that differs with the application. This makes it possible to provide the highly reliable semiconductor device at low costs.

The semiconductor device management system 100 according to the first modification is configured to have the arithmetic operation device provided with the adaptability calculation section (matching rate calculation section 113) for calculating adaptability of the semiconductor device for each application using the three-dimensional position information (three-dimensional defect information 143) of the crystal defect contained in the semiconductor substrate, the influence rate (defect influence rate 144) of the defect with respect to the device specification, and the operation condition 145 of the semiconductor device for each application, and the determination section 116 for determining the application to the semiconductor device formed on the semiconductor substrate based on the adaptability so that data for outputting at least the respective determined applications are generated. This allows the semiconductor device management system 100 to output the information for selection of the semiconductor device from the inspection result 142 of the semiconductor substrate defect with reference to the influence rate (defect influence rate 144) of the defect with respect to the device specification, and the device operation condition 145 which differs with the application. It is possible to selectively manufacture the semiconductor substrate adapted to the device operation condition 145 that differs with the application. This makes it possible to provide the highly reliable semiconductor device at low costs.

The present invention is not limited to examples as described above, but includes various modifications and equivalent structures without departing from the spirit of the appended claims. For example, the examples are described in detail for readily understanding of the present invention which is not necessarily limited to the one equipped with all the structures as described above. It is possible to replace a part of the structure of one embodiment with the structure of another embodiment. The one example may be provided with an additional structure of another embodiment. It is further possible to add, remove, and replace the other structure to, from and with a part of the structure of the respective examples.

The respective structures, functions, processing sections, processing means, and the like may be realized through hardware by designing those sections partially or entirely using the integrated circuit. They may also be realized through software by the processor for interpreting and executing the program to implement the respective functions.

Information of the program, table, file, and the like for realizing the respective functions may be stored in a storage unit such as a memory, hard disk, and SSD (Solid State Drive), or a recording medium such as an IC (Integrated Circuit) card, SD (Secure Digital memory) card, and DVD (Digital Versatile Disc).

The foregoing examples show the control lines and information lines which are considered as necessary for the explanation. However, they do not necessarily indicate all the control lines and the information lines of the product. It may be considered that almost all the structures are interconnected with one another.

## Claims

1. A semiconductor device management system comprising an arithmetic operation device for executing a predetermined process, an input section for receiving an input of data, and an output section for outputting an execution result of the process, wherein,
the arithmetic operation device includes an adaptability calculation section for calculating adaptability of a semiconductor device formed on a semiconductor substrate for each application using three-dimensional position information of a crystal defect contained in the semiconductor substrate, an influence rate of a defect with respect to a device specification, and an operation condition of the semiconductor device for each application,
the arithmetic operation device includes a determination section for determining each application to the semiconductor devices based on the adaptability, and
the determination section generates data for outputting at least each of the determined applications.

2. The semiconductor device management system according to claim 1, wherein,
the arithmetic operation device includes an application classification section which classifies the semiconductor device in accordance with the adaptability, and stores a classification result in a database,
the arithmetic operation device includes a listing section which makes a list of the database, and
the determination section determines each application to the semiconductor devices based on a result of classification performed by the application classification section, and selects the semiconductor device classified as being highly adapted to the determined application.

3. The semiconductor device management system according to claim 1, wherein
the adaptability calculation section calculates the adaptability of the semiconductor device formed on the semiconductor substrate for each application using the three-dimensional position information of the crystal defect contained in the semiconductor substrate, three-dimensional position information of a process defect which occurs in manufacturing of the semiconductor device, the influence rate of the defect with respect to the device specification, and the operation condition of the semiconductor device for each application.

4. The semiconductor device management system according to claim 3, wherein,
the arithmetic operation device includes a defective/relief rate calculation section for calculating a defective rate and a relief rate of the respective semiconductor devices, and
the defective/relief rate calculation section:
calculates the defective rate for each application as a probability that electrical characteristics of the semiconductor device formed on the semiconductor substrate do not satisfy a desired condition using the three-dimensional position information of the crystal defect contained in the semiconductor substrate, the three-dimensional position information of the process defect which occurs in manufacturing of the semiconductor device, the influence rate of the defect with respect to the device specification, and the operation condition of the semiconductor device for each application;
calculates the relief rate for each application as a probability that electrical characteristics satisfy a desired condition through inactivation of the process defect by changing a manufacturing process subsequent to occurrence of the process defect; and
instructs to change the subsequent manufacturing process of the semiconductor device having the calculated defective rate larger than a predetermined threshold value, and having the calculated relief rate larger than a predetermined threshold value.

5. The semiconductor device management system according to claim 1, wherein
the adaptability calculation section calculates the adaptability of the semiconductor device for each application using the three-dimensional position information of the crystal defect contained in the semiconductor substrate, process condition history in manufacturing of the semiconductor device, the influence rate of the defect with respect to the device specification, and the operation condition of the semiconductor device for each application.

6. The semiconductor device management system according to claim 5, wherein
the adaptability calculation section calculates the adaptability of the semiconductor device for each application using the three-dimensionalposition information of the crystal defect contained in the semiconductor substrate, three-dimensional position information of a process defect which occurs in manufacturing of the semiconductor device, the process condition history in manufacturing of the semiconductor device, the influence rate of the defect with respect to the device specification, and the operation condition of the semiconductor device for each application.

7. The semiconductor device management system according to claim 6, wherein,
the arithmetic operation device includes a defective/relief rate calculation section for calculating a defective rate and a relief rate of the respective semiconductor devices, and
the defective/relief rate calculation section:
calculates the defective rate for each application as a probability that electrical characteristics of the semiconductor device formed on the semiconductor substrate do not satisfy a desired condition using the three-dimensional position information of the crystal defect contained in the semiconductor substrate, the three-dimensional position information of the process defect which occurs in manufacturing of the semiconductor device, the influence rate of the defect with respect to the device specification, and the operation condition of the semiconductor device for each application;
calculates the relief rate for each application as a probability that electrical characteristics satisfy a desired condition through inactivation of the process defect by changing a manufacturing process subsequent to occurrence of the process defect; and
instructs to change the subsequent manufacturing process of the semiconductor device having the calculated defective rate larger than a predetermined threshold value, and having the calculated relief rate larger than a predetermined threshold value.

8. The semiconductor device management system according to claim 1, wherein
the adaptability calculation section:
acquires the influence rate of the defect with respect to the device specification;
calculates a matching contribution rate for each defect from the acquired influence rate;
calculates a statistic value of the matching contribution rates for each of the defects to obtain the matching contribution rate for each semiconductor chip; and
calculates a statistic value of the matching contribution rates of all device specifications for each of the application and the semiconductor chip to obtain the adaptability for each of the application and the semiconductor chip.

9. The semiconductor device management system according to claim 1, wherein
the adaptability calculation section calculates the adaptability using a defect type and a shape of the crystal defect.

10. The semiconductor device management system according to claim 1, further comprising
a defect analysis section which acquires a result of inspection of the semiconductor substrate, performed by an inspection device to analyze a three-dimensional defect of the semiconductor substrate.

11. A semiconductor device management system comprising an arithmetic operation device for executing a predetermined process, an input section for receiving an input of data, and an output section for outputting an execution result of the process, wherein,
the arithmetic operation device includes an adaptability calculation section for calculating adaptability of a semiconductor substrate for each application using three-dimensional position information of a crystal defect contained in the semiconductor substrate, an influence rate of a defect with respect to a device specification, and an operation condition of a semiconductor device for each application,
the arithmetic operation device includes a determination section for determining each application to the semiconductor devices based on the adaptability, and
the determination section generates data for outputting at least each of the determined applications.

12. The semiconductor device management system according to claim 11, wherein,
the arithmetic operation device includes an application classification section which classifies the semiconductor substrate in accordance with the adaptability, and stores a classification result in a database,
the arithmetic operation device includes a listing section which makes a list of the database, and
the determination section determines each application to the semiconductor substrate based on the result of classification performed by the application classification section, and selects the semiconductor substrate classified as being highly adapted to the determined application.

13. A semiconductor device management method implemented by a computing machine, the computing machine including an arithmetic operation device for executing a predetermined process, an input section for receiving an input of data, and an output section for outputting an execution result of the process,
the semiconductor device management method allows the arithmetic operation device to execute:
an adaptability calculation step of calculating adaptability of a semiconductor device for each application using three-dimensional position information of a crystal defect contained in a semiconductor substrate, an influence rate of a defect with respect to a device specification, and an operation condition of the semiconductor device for each application;
a determination step of determining each application to the semiconductor devices formed on the semiconductor substrate based on the adaptability; and
an output step of generating data for outputting at least each of the applications determined in the determination step.
